Europäisches Patentamt

European Patent Office

Office européen des brevets

(19)

(11) Numéro de publication : **0 095 418**
**B1**

# (12) FASCICULE DE BREVET EUROPÉEN

(45) Date de publication du fascicule du brevet :
**30.07.86**

(21) Numéro de dépôt : **83401017.5**

(22) Date de dépôt : **20.05.83**

(51) Int. Cl.⁴ : **H 01 L 27/10, H 03 K 19/177**

(54) **Circuit intégré logique conçu de manière à simplifier son implantation sur un substrat.**

(30) Priorité : **25.05.82 FR 8209052**

(43) Date de publication de la demande :
**30.11.83 Bulletin 83/48**

(45) Mention de la délivrance du brevet :
**30.07.86 Bulletin 86/31**

(84) Etats contractants désignés :
**CH DE FR GB LI NL**

(56) Documents cités :
**FR-A- 2 395 647**
**IBM TECHNICAL DISCLOSURE BULLETIN, vol. 19, no. 6, novembre 1976, pages 2303-2304, New York, USA P.W. COOK et al.: "Polysilicon gate MOSFETS for Weinberger-type random logic arrays"**
**IEEE TRANSACTIONS ON COMPUTERS, vol. C-28, no. 9, septembre 1979, pages 594-601, New York, USA S.S. PATIL et al.: "A programmable logic approach for VLSI"**
**IBM TECHNICAL DISCLOSURE BULLETIN, vol. 19, no. 6, novembre 1976, pages 2262-2265, New York, USA V.L. RIDEOUT: "Logic arrays with polysilicon gate lines"**

(73) Titulaire : **SOCIETE POUR L'ETUDE ET LA FABRICATION DE CIRCUITS INTEGRES SPECIAUX - E.F.C.I.S. 17, avenue des Martyrs F-38100 Grenoble (FR)**

(72) Inventeur : **Meyer, Jacques THOMSON-CSF SCPI 173, bld Haussmann F-75379 Paris Cedex 08 (FR)**
Inventeur : **Cru, Roger THOMSON-CSF SCPI 173, bld Haussmann F-75379 Paris Cedex 08 (FR)**

(74) Mandataire : **Guérin, Michel et al THOMSON-CSF SCPI 19, avenue de Messine F-75008 Paris (FR)**

## Description

La présente invention concerne les circuits intégrés logiques et elle a pour but de proposer un type de structure intégrée tel que l'implantation de ces circuits sur un substrat, c'est-à-dire leur mise en place géométrique, et le dessin des masques de fabrication correspondants soient facilités pour le concepteur de circuits.

Dans l'étude d'un nouveau circuit intégré, une durée de travail très importante doit être consacrée à l'implantation (positionnement) des divers éléments de circuit (transistors, interconnexions) sur la surface disponible, et au dessin des masques de fabrication.

La difficulté de cette tâche provient de la nécessité de concevoir des interconnexions respectant les possibilités technologiques de croisement, en réduisant autant que possible l'encombrement du circuit. Elle provient aussi du caractère fastidieux du dessin des masques lorsque les circuits comprennent un grand nombre d'éléments. On cherche donc, par la conception assistée par ordinateur, à automatiser l'implantation de certains types de circuits en utilisant des bibliothèques de schémas d'implantation, et aussi en utilisant des structures répétitives pour lesquelles l'ordinateur n'a qu'à répéter un motif de dessin à des endroits qui lui sont indiqués par le concepteur.

Un exemple typique de structure répétitive est fourni par les réseaux logiques programmables (PLA, de l'anglais Programmable Logic Array). Ces réseaux sont destinés, à partir de n variables d'entrée, à fournir p combinaisons logiques de ces variables ou de certaines de ces variables ; ces p combinaisons sont des fonctions booléennes des variables et peuvent se ramener chacune à une somme de produits des variables. Lorsqu'on veut gagner sur le temps d'implantation, au prix éventuellement d'une certaine perte en densité d'occupation de la surface disponible, on ne se préoccupera pas de dessiner un agencement optimal de transistors et d'interconnexions, tenant compte des fonctions logiques particulières à réaliser, mais on réalisera l'implantation systématiquement sous forme de réseau matriciel de conducteurs de lignes et de conducteurs de colonnes avec un transistor de connexion ou une absence de connexion à chaque croisement de conducteurs, les positions des transistors étant déterminées par les combinaisons logiques à réaliser.

Cette structure matricielle permet de gagner un temps considérable sur le dessin du circuit, mais elle n'est a priori utilisable que pour la réalisation de fonctions logiques qui peuvent s'exprimer sous forme de produits, ou sommes, ou sommes de produits de variables logiques, on l'a donc utilisée pour réaliser des décodeurs, des mémoires, des réseaux logiques programmables.

Un exemple de réseau PLA comportant des fonctions ET et OU, d'ailleurs regroupées dans une même zone d'interconnexions, est connu d'après le brevet FR-A-2 395 647.

On reviendra sur les détails de réalisation d'une structure intégrée répétitive du type PLA, mais on peut déjà indiquer que le but de la présente invention est de proposer une structure intégrée améliorée qui permet de faciliter l'implantation de circuits logiques même lorsqu'ils ne peuvent pas s'exprimer sous forme de sommes de produits de variables d'entrée. En particulier, la présente invention a pour but de faciliter, grâce à une structure répétitive, l'implantation de circuits logiques tels que des bascules, compteurs, registres, qui comportent des bouclages entre sorties et entrées de portes logiques excluant la possibilité d'une réalisation sous forme de structure PLA.

La structure intégrée selon l'invention se présente de la manière suivante :

un réseau régulier de conducteurs en lignes et un réseau régulier de conducteurs en colonne se croisent dans une zone d'implantation du circuit logique (ou d'une portion du circuit logique) à réaliser ;

certaines régions de croisement entre un conducteur de ligne et un conducteur de colonne comportent une isolation entre ces deux conducteurs, tandis que d'autres comportent un transistor de disposition dite « normale » ayant une électrode principale reliée à un conducteur de colonne et une électrode de commande reliée à un conducteur de ligne ;

mais de plus, contrairement aux structures de type PLA ou aux mémoires et décodeurs, certaines autres régions de croisement, entre une ligne et une colonne qui par ailleurs sont toutes deux reliées à des transistors de disposition normale, comportent un transistor de disposition dite « inversée », c'est-à-dire ayant une électrode principale reliée au conducteur de ligne (et non de colonne) et une électrode de commande reliée au conducteur de colonne (et non de ligne). D'autres régions de croisement peuvent comprendre un court-circuit entre le conducteur de ligne et le conducteur de colonne.

On comprendra que les termes ligne et colonne sont des dénominations parfaitement arbitraires et n'impliquent en rien une obligation de dessin où les lignes seraient horizontales et les colonnes verticales.

Le terme « électrode » de transistor doit s'entendre très généralement même s'il ne s'agit pas à proprement parler d'un conducteur : la région diffusée de source ou de drain d'un transistor MOS est considérée ici comme une électrode de source ou drain (électrode principale par opposition à la grille du transistor qui est une électrode de commande).

La structure en réseau selon l'invention pourra donc comprendre, dans une même zone quadrillée par des conducteurs perpendiculaires, soit trois types de régions de croisement (isolation, transistor normal, transistor inversé), soit quatre types de région de croisement (isolation, transistor normal, transistor inversé, court-circuit), en tous cas un petit nombre de motifs de dessin dont la répétitivité facilite grandement la phase de conception. Avec une conception assistée par ordinateur, le travail essentiel consistera à définir sur le réseau les emplacements de chacun des types de connexion, l'ordinateur établissant alors le dessin des masques de tout le circuit par mise en place de motifs connus aux positions désignées.

Il faut bien comprendre que non seulement ces trois ou quatre types de régions de croisement cohabitent dans une même zone d'implantation (cf. brevet FR-A-2 395 647), et non dans des zones géographiquement séparées, mais de plus, ici, des court-circuits ou des transistors inversés se situeront au carrefour d'une ligne et d'une colonne qui toutes deux sont reliées par ailleurs, dans d'autres régions de croisement de la même zone d'implantation, à des transistors de disposition « normale ».

L'invention sera mieux comprise à la lecture de la description détaillée qui suit et qui est faite en référence aux dessins annexés dans lesquels :

la figure 1 représente sous forme symbolique un exemple particulier de réseau logique programmable ;

la figure 2 représente sa réalisation pratique sous forme de structure classique en double réseau ;

la figure 3 en représente une figuration symbolique ;

la figure 4 représente un compteur synchrone qui ne serait pas réalisable sous forme de structure de type PLA ;

la figure 5 représente symboliquement une implantation en réseau, selon l'invention, pour le circuit de la figure 4 ;

la figure 6 représente un circuit logique qu'il ne serait pas intéressant d'implanter sous forme de structure PLA ;

la figure 7 représente symboliquement une implantation en réseau, selon l'invention, du circuit de la figure 6 ;

les figures 8 à 10 représentent des motifs élémentaires de la structure intégrée selon l'invention.

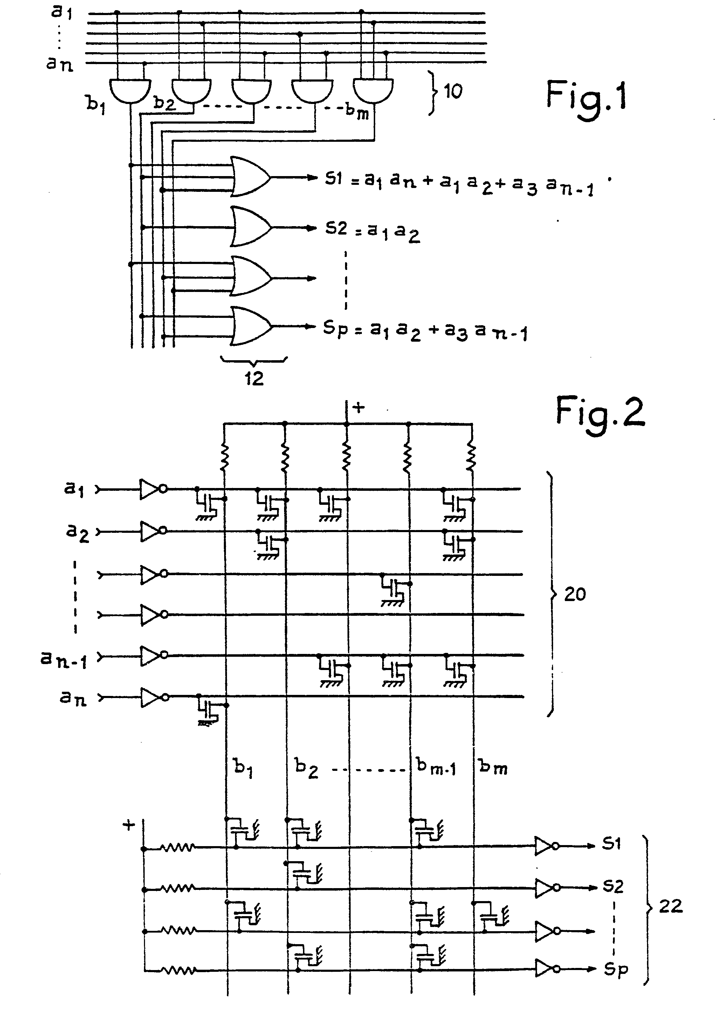

Les figures 1 à 3 sont destinées à mieux faire comprendre la technique connue d'implantation des structures PLA pour montrer comment l'invention s'en détache.

Un réseau logique programmable réalise des combinaisons logiques SI à Sp qui sont des sommes de produits logiques de variables d'entrée $a_1$ à $a_n$.

Il se décompose en un réseau « produit » (portes ET 10) à n entrées ($a_1$ à $a_n$) et m sorties ($b_1$ à $b_m$) établissant les différents produits intermédiaires apparaissant dans les combinaisons à réaliser, et un réseau « somme » (portes OU 12) à m entrées ($b_1$ à $b_m$) et p sorties (SI à Sp) établissant les sommes de produits.

La figure 1 montre un exemple d'un tel réseau.

En pratique, on remplace les portes ET par des portes NOR (NON-OU) précédées d'inverseurs, et les portes OU par des portes NOR suivies d'inverseurs, car une porte NOR à k entrées est très facile à réaliser avec k transistors ayant chacun leur électrode de commande (grille d'un transistor MOS) reliée à une ligne conductrice d'entrée respective, une électrode principale (source d'un transistor MOS) reliée à une ligne de masse commune aux k transistors, et une autre électrode principale (drain) reliée à une colonne de sortie, également commune et reliée, à travers une charge, à un potentiel d'alimentation.

La figure 2 montre la structure PLA de la figure 1 implantée selon un double réseau matriciel de portes NOR. Un premier réseau 20 réalise la fonction « produit » et un deuxième réseau 22 réalise la fonction « somme ». Ces réseaux sont implantés dans des zones géographiquement séparées. Dans le premier réseau 20, les régions de croisement entre conducteurs de ligne et conducteurs de colonne comprennent soit une isolation, soit un transistor connecté comme indiqué ci-dessus. Dans le deuxième réseau, c'est la même chose, mais ce qui était colonne de sortie du premier réseau devient ligne d'entrée pour le deuxième.

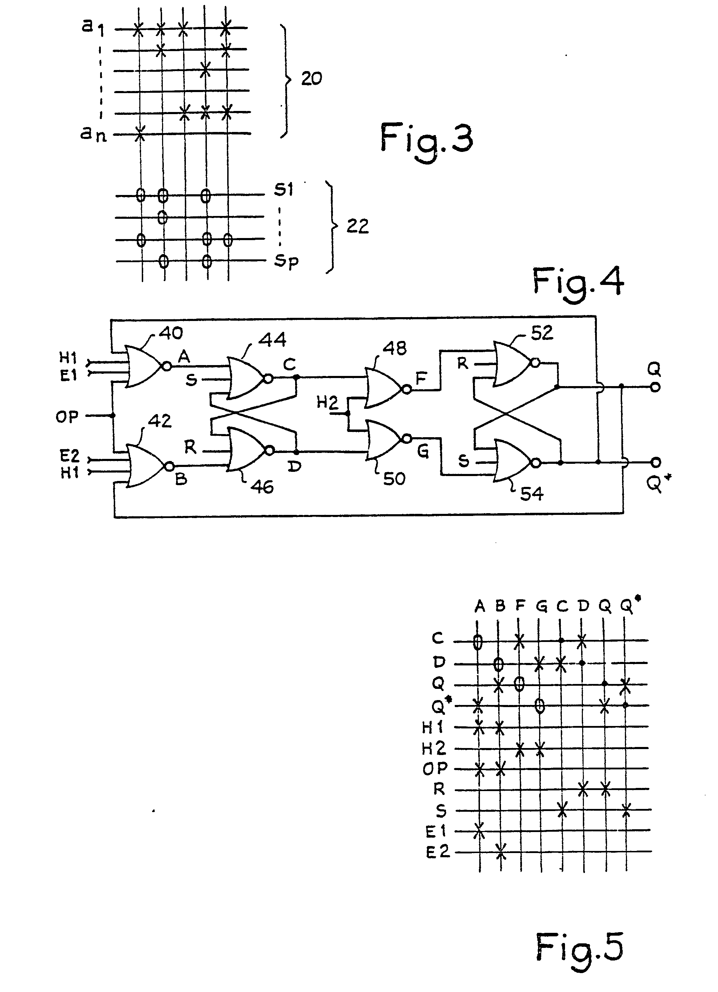

La figure 3 symbolise le réseau de la figure 2 avec une convention dans laquelle les conducteurs de ligne sont des traits horizontaux et les conducteurs de colonne des traits verticaux ; les transistors sont figurés par un X s'ils sont normaux (grille reliée à une ligne) et par un 0 s'ils sont inversés (grille reliée à une colonne). Les croisements avec isolation entre conducteurs sont figurés sans aucun symbole particulier au croisement de deux traits. Les inverseurs n'ont pas été figurés.

Le schéma se divise donc en une zone d'implantation 20 où n'apparaissent que des transistors X et une zone 22 où n'apparaissent que des transistors 0. En réalité, on aurait pu tout aussi bien représenter ce schéma symbolique avec uniquement des transistors normaux X dans les deux réseaux 20 et 22, en considérant que le deuxième réseau est bien distinct du premier et est analogue au premier mais qu'il est tourné de 90° et qu'il possède des lignes d'entrées verticales au lieu d'horizontales.

Physiquement, les motifs de dessin des transistors du deuxième réseau seront d'ailleurs tout à fait semblables à ceux du premier mais tournés de 90 degrés ; en particulier, si les conducteurs d'entrée du premier réseau sont en silicium polycristallin et les conducteurs de sortie en aluminium, le concepteur d'une structure PLA n'utilisera pas ces conducteurs d'aluminium pour attaquer le deuxième réseau : il les prolongera par des conducteurs en silicium polycristallin qui deviendront des lignes d'entrée (verticales) du deuxième réseau, lequel aura alors des colonnes de sortie (horizontales) en aluminium selon une structure tout à fait semblable à celle du premier réseau.

Ceci montre bien que dans une structure de type PLA tous les transistors jouent le même rôle et peuvent être dessinés tous de la même manière ; ceci résulte du fait que la structure comporte des réseaux en cascade et du fait qu'à l'intérieur de chaque réseau, toutes les entrées sont appliquées aux lignes et toutes les sorties sont prélevées sur les colonnes.

Selon la présente invention, on établit des structures en réseau dans lesquelles les variables d'entrée et les variables de sortie de portes logiques (portes intermédiaires ou portes de sortie finales) sont mélangées et peuvent apparaître aussi bien en ligne qu'en colonne, et parfois des deux côtés à la fois pour une même variable.

Ces structures permettront notamment de réaliser des circuits dans lesquels il y a une imbrication de connexions telle que par exemple une porte NOR reçoive comme signaux d'entrée à la fois des variables d'entrée du circuit et des sorties d'autres portes NOR. Elles permettront aussi de réaliser des circuits logiques bouclés, ce qui est particulièrement utile pour la réalisation de bascules, compteurs, registres et de toutes sortes de circuits qui peuvent se dessiner symboliquement à l'aide de portes NOR essentiellement, mais qui ne peuvent pas ou peuvent difficilement se ramener à des structures de type PLA, et qui n'ont donc jamais été implantés sous forme de réseau croisé de lignes et colonnes à motifs simples répétés.

Les structures selon l'invention font apparaître des transistors normaux et inversés, et éventuellement des court-circuits, véritablement dans la même zone d'implantation, ce qu'on va expliquer à propos d'un exemple qui est un compteur synchrone représenté à la figure 4 par un circuit à portes NOR.

Ce circuit est classique et ne nécessite pas de commentaires particuliers. Les signaux d'entrée extérieurs sont désignés par E1, E2 (entrées), H1, H2 (horloges) R, S (remise à zéro, forçage), OP (validation) et les sorties complémentaires par Q et Q*.

Une porte NOR 40 reçoit OP, H1, E1, Q*, sa sortie est désignée par A ; une porte NOR 42 reçoit OP, H1, E2, Q ; sa sortie est désignée par B.

Une porte NOR 44 et une porte NOR 46, de sorties C et D respectivement, reçoivent la première les signaux A, S et D, et la seconde les signaux B, R et C.

Une porte NOR 48 reçoit H2 et C et une porte NOR 50 reçoit H2 et D ; les sorties sont F et G respectivement.

Enfin, une porte NOR 52 reçoit F, R et Q* et une porte NOR 54 reçoit G, S et Q ; les sorties sont Q et Q*.

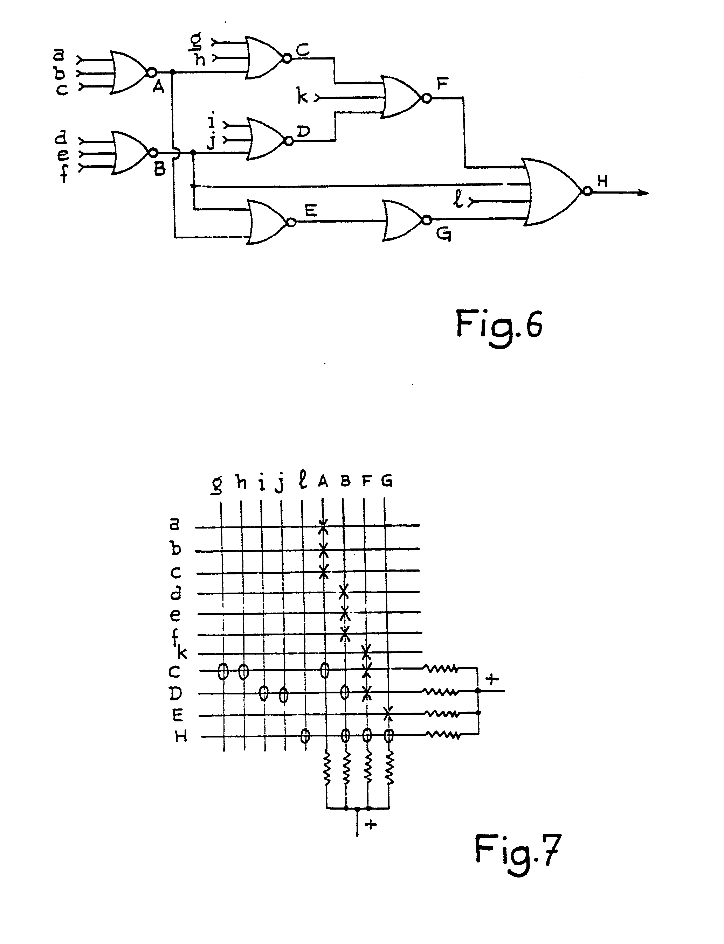

La figure 5 représente un schéma symbolique d'implantation en réseau, conformément à l'invention, du circuit de la figure 4, avec les conventions de la figure 3, auxquelles il faut ajouter la représentation par un point noir renforcé d'un court-circuit entre deux conducteurs perpendiculaires.

Sur le schéma de la figure 5, on a établi des conducteurs horizontaux dont certains reçoivent des signaux d'entrée H1, H2, E1, E2, OP, R, S, mais dont certains autres constituent des sorties de portes NOR (C, D) y compris les sorties du compteur lui-même (Q, Q*). Certains signaux (C, D, Q, Q*) apparaissent aussi bien sur les lignes horizontales que sur les colonnes verticales et un point noir à l'intersection d'une ligne et d'une colonne correspondant au même signal représente un court-circuit entre le conducteur de ligne et le conducteur de colonne.

Toutes les entrées et sorties de portes NOR doivent apparaître chacune au moins une fois en ligne ou en colonne.

Dans le cas de la figure 5, toutes les sorties de portes NOR apparaissent sur les colonnes verticales et chaque colonne verticale (par exemple la première à gauche) correspond à une porte NOR (40) de la même manière que pour le réseau 20 de la figure 3, c'est-à-dire qu'un transistor « normal » X est placé à l'intersection de cette colonne et de chacune des lignes correspondant aux signaux d'entrée de la porte NOR (H1, E1, OP, Q* pour la porte 40 de sortie A). Ce transistor « normal » X a sa grille reliée à une ligne, son drain relié à une colonne et sa source reliée à la masse. Les colonnes sont reliées à travers des charges individuelles (résistances ou transistors) non représentées, à un potentiel d'alimentation, comme à la figure 2.

L'implantation se fait donc de manière similaire à celle d'une structure PLA avec en outre des court-circuits entre lignes et colonnes dans la même zone d'implantation que les transistors « normaux », c'est-à-dire que les points de court-circuit se situent au croisement de lignes et colonnes qui comportent par ailleurs des transistors « normaux ».

De plus, des transistors inversés, figurés par un O, sont situés dans la même zone d'implantation que les transistors normaux, donc à des croisements situés sur les mêmes lignes et les mêmes colonnes que les transistors normaux.

Pour les variables qui apparaissent à la fois en ligne et en colonne et qui sont des sorties de portes NOR, on remarque que les entrées de ces portes peuvent se situer soit en ligne (avec un transistor normal) soit en colonne (avec un transistor inversé). Par exemple, la variable de sortie D correspond à la sortie de la porte NOR 46 qui doit recevoir comme entrées les variables C, R, et B. La colonne D devrait donc être commandée par trois transistors normaux aux intersections des lignes C, R et B. En réalité on peut se dispenser de la ligne B et utiliser à la place une colonne B. On commande alors la colonne D et la ligne D (réunies) d'une part par deux transistors normaux à l'intersection de la colonne D et des lignes C et R, et d'autre part par un transistor inversé à l'intersection de la ligne D et de la colonne B (le transistor inversé ayant sa grille reliée à la colonne B, son drain à la ligne D et sa source à la masse).

Les courts-circuits entre lignes et colonnes correspondant à une même variable dispensent de prévoir de relier les lignes comportant des transistors inversés à un potentiel d'alimentation par l'intermédiaire de charges, bien que ces lignes correspondent à des sorties de portes NOR : les charges des colonnes correspondantes sont des charges aussi pour les lignes. Mais si une ligne comportait un transistor inversé sans que cette ligne soit reliée par un court-circuit à une colonne, il faudrait prévoir en bout de cette ligne une liaison par une charge à un potentiel d'alimentation pour que cette ligne joue le rôle de sortie d'une porte NOR dont les entrées sont commandées par des colonnes.

La figure 6 représente un exemple de circuit logique sans bouclage et qui pourrait théoriquement être mis sous forme de structure PLA mais qui comporte des imbrications telles qu'il est plus simple de le réaliser avec la structure de la présente invention car la sortie du circuit s'exprime mieux sous forme d'une fonction logique comprenant des mises en facteurs imbriquées que sous forme d'une somme de produits de variables d'entrée.

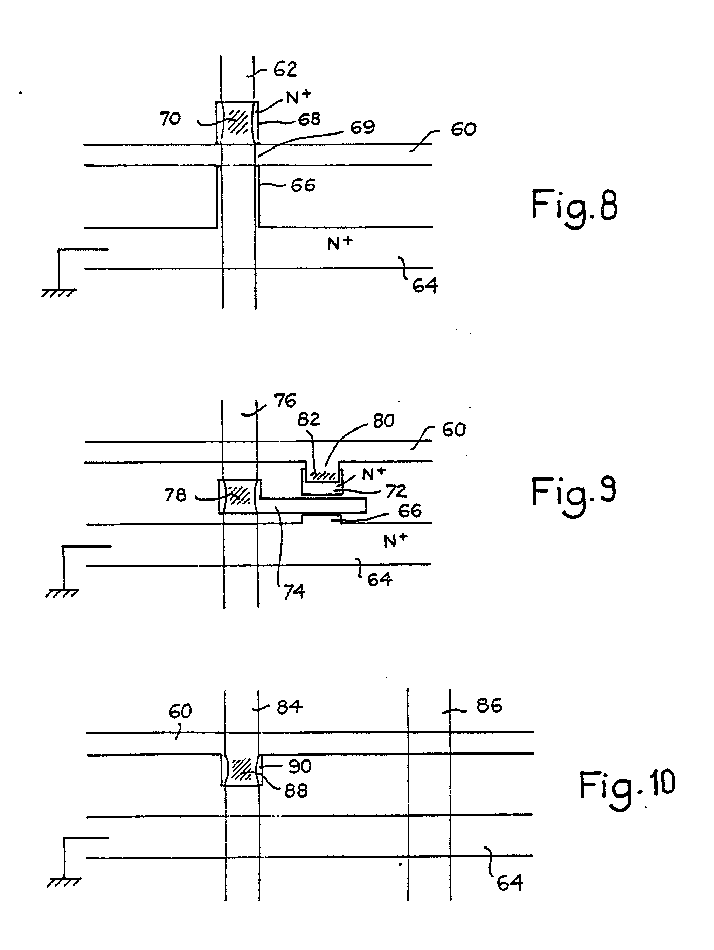

Le schéma de la figure 7 représente symboliquement l'implantation du circuit de la figure 6 sous forme d'un réseau comprenant des transistors normaux et des transistors inversés.

Les variables d'entrée apparaissent aussi bien en ligne (a, b, c, d, e, f, k) qu'en colonne (g, h, i, j, l).

Les variables de sortie de portes NOR également peuvent apparaître en colonne (A, B, F, G) ou en ligne (C, D, E, H). Ici aucune variable n'apparaît à la fois en ligne et en colonne et, par conséquent, d'une part il n'y a pas de points de court-circuit entre ligne et colonne dans le réseau, et d'autre part les lignes ou colonnes correspondant à une sortie de porte NOR (A, B, C, D, E, F, G, H) doivent être reliées par des charges individuelles (résistance ou transistor de charge) à un potentiel d'alimentation.

Les sorties A et B ont été placées en colonne car elles dépendent des variables a, b, c, d, e, f toutes placées en ligne. Des transistors normaux X le long de ces colonnes rendent compte de cette dépendance.

Les sorties C, D, E ont été placées en ligne car elles dépendent de variables A, B en colonne ; elles dépendent aussi de variables g, h, i, j, qu'on place alors aussi en colonne. Des transistors inversés 0 le long des lignes C, D, E rendent compte de cette dépendance.

Les sorties F, G sont à nouveau placées en colonne car elles dépendent de C, D, E qui sont en ligne. Comme elles dépendent aussi de k et l, on place les variables k et l en ligne. Des transistors normaux X le long des colonnes F et G rendent compte de cette dépendance des colonnes par rapport aux lignes.

Enfin, la sortie H est placée en ligne et un transistor inversé 0 est placé au croisement de cette ligne et de chacune des colonnes B, F, I, G puisque ces variables sont appliquées à l'entrée de la dernière porte NOR correspondant à la sortie H.

La figure 7 montre donc un exemple de structure selon l'invention avec, aux croisements du réseau, soit une isolation entre conducteurs, soit un transistor normal (commandé par une ligne), soit un transistor inversé (commandé par une colonne). La différence avec une structure PLA est, comme le montre une comparaison immédiate des figures 7 et 3, dans le fait que les transistors normaux et inversés sont mélangés dans le même réseau : une bonne partie des transistors inversés (0) se situent à un croisement d'une ligne et d'une colonne le long desquelles on trouve par ailleurs des transistors normaux (X).

Les structures en réseau ainsi obtenues peuvent être simplifiées éventuellement par réorganisation des positions des variables sur les lignes et les colonnes, par suppression d'espaces où ne figurent aucune interconnexion entre lignes et colonnes, par remplacement de deux transistors inversés par deux transistors normaux lorsqu'on rencontre quatre points adjacents comportant respectivement deux court-circuits diagonalement opposés et deux transistors inversés diagonalement opposés.

On va maintenant décrire, en référence aux figures 8 à 10, une possibilité de réalisation pratique de la structure selon l'invention, montrant comment réaliser sur un même réseau les différentes sortes de croisement de conducteurs (transistor normal, transistor inversé, court-circuit, isolation).

L'exemple est défini pour une structure de type MOS (métal-oxyde-semiconducteur), à un niveau de silicium polycristallin et un niveau d'aluminium, pouvant être fabriquée par des procédés classiques.

Les conducteurs de ligne sont en silicium polycristallin fortement dopé, et les conducteurs de colonne en aluminium.

Dans une zone de croisement avec isolation, les conducteurs de ligne et de colonne sont isolés l'un de l'autre par une couche isolante épaisse (oxyde épais de silicium), et isolés aussi du substrat de la même manière. Dans une zone de croisement avec court-circuit, l'aluminium descend en contact avec le silicium polycristallin.

Là où il y a un transistor, du silicium polycristallin sert de grille et n'est isolé du substrat que par une couche isolante mince (oxyde mince de silicium).

Les sources et drains des transistors sont réalisés par des zones fortement dopées du substrat (diffusion $N^+$ pour un transistor à canal N), les sources étant en fait des extensions latérales d'une ligne de masse (constituée par une diffusion $N^+$), courant entre deux lignes de silicium polycristallin (une ligne de masse est prévue seulement pour deux lignes de silicium polycristallin et les transistors sont placés symétriquement de chaque côté de cette ligne de masse). Les drains sont bien entendu séparés des sources par une région de canal au-dessous de la partie de silicium polycristallin qui forme grille.

Pour préciser ces notions, on a représenté à la figure 8 un schéma simplifié (vu de dessus) d'une zone de croisement avec transistor normal : la ligne de silicium polycristallin est désignée par 60, la colonne d'aluminium par 62, la diffusion $N^+$ de ligne de masse par 64 avec une extension 66 qui forme la source. La diffusion $N^+$ de drain est désignée par 68. Le canal du transistor MOS est situé entre source et drain sous le passage de la ligne 60.

La ligne de silicium polycristallin 60 est isolée du substrat par de l'oxyde épais sauf au passage entre la source et le drain où elle constitue une grille 69 et où elle n'est plus isolée que par de l'oxyde mince.

La colonne d'aluminium 62 est isolée du substrat (notamment de la source et de la ligne de masse) ainsi que de la ligne de silicium 60, par de l'oxyde épais, sauf dans la région du drain où l'aluminium vient en contact avec le substrat (zone hachurée 70).

La figure 9 montre en vue de dessus la constitution schématique d'un transistor de disposition inversée.

La source est encore une extension 66 de la ligne de masse 64. Le drain est aussi une région diffusée $N^+$ 72 séparée de la source, mais cette fois située entre la ligne de masse 64 et la ligne de silicium polycristallin 60, cette dernière ne servant plus de grille. Le drain est décalé latéralement par rapport aux colonnes d'aluminium.

La grille est formée par une portion isolée 74 de silicium polycristallin, déposée et gravée en même temps que les lignes 60 ; cette portion passe au-dessus de l'intervalle entre source 66 et drain 72, et, dans cet intervalle, elle n'est isolée du substrat que par de l'oxyde mince. De plus, cette portion s'étend latéralement jusqu'à la colonne d'aluminium (76 sur la figure 9) et à cet endroit l'aluminium est en contact avec le silicium polycristallin (zone hachurée 78) alors qu'ailleurs il est isolé par de l'oxyde épais (notamment là où il croise la ligne de silicium polycristallin 60).

Enfin, la ligne de silicium polycristallin 60 ou une extension 80 de cette ligne vient en contact direct avec le substrat au niveau du drain 72 (zone hachurée 82).

Une zone de croisement de ligne 60 et de colonne 84 avec court-circuit et une zone de croisement de ligne 60 et de colonne 86 avec isolation ont été représentées côte à côte sur la figure 10. Pour le court-circuit, l'aluminium vient en contact (zone hachurée 88) avec la ligne de silicium polycristallin 60 qui est élargie par une extension 90 au niveau du croisement ; dans le croisement avec isolation, l'aluminium passe au-dessus du silicium polycristallin dont il est séparé par de l'oxyde épais. Dans les deux types de croisement l'aluminium est isolé aussi du substrat (notamment de la ligne de masse 64) par de l'oxyde épais.

Ces différents modèles de zones de croisement permettent de définir des motifs élémentaires répétitifs de masques de fabrication, motifs élémentaires qui peuvent être directement mis en place côte à côte par un ordinateur d'assistance à la conception, le concepteur indiquant quel motif doit être placé à tel ou tel croisement de ligne et colonne.

**Revendications**

1. Circuit intégré logique comportant un réseau de conducteurs en ligne et un réseau de conducteurs en colonne se croisant dans une zone d'implantation de portes logiques, certaines régions de croisement entre un conducteur de ligne et un conducteur de colonne comportant une isolation entre ces deux conducteurs et d'autres régions comportant un transistor de disposition dite « normale » (X) ayant une électrode principale (68) reliée à un conducteur de colonne (62) et une électrode de commande (69) reliée à un conducteur de ligne (60), caractérisé par le fait que d'autres régions de croisement, entre un conducteur de ligne et un conducteur de colonne qui sont par ailleurs tous deux reliés au niveau de régions de croisements de la même zone d'implantation, à des transistors de disposition normale, comportent un transistor de disposition dite « inversée » (0) ayant une électrode principale (72) reliée au conducteur de ligne (60) et une électrode de commande (74) reliée au conducteur de colonne (76).

2. Circuit intégré logique selon la revendication 1 caractérisé par le fait que la zone d'implantation comporte simultanément des régions de croisement avec court-circuit entre le conducteur de ligne et le conducteur de colonne et d'autres avec un transistor de disposition inversée.

3. Circuit intégré logique selon l'une quelconque des revendications 1 et 2, caractérisé par le fait qu'une autre électrode principale (66) des transistors de disposition inversée et des transistors de disposition normale est reliée à une ligne de masse (64) commune à plusieurs transistors de la zone d'implantation.

4. Circuit intégré logique selon l'une quelconque des revendications 1 à 3, caractérisé par le fait que certaines colonnes (A, B, F, G ; fig. 7) sont reliées, à travers des charges individuelles, à une source de potentiel d'alimentation, et que certaines lignes (C, D, E, H ; fig. 7) sont également reliées, à travers des charges individuelles, à une source de potentiel d'alimentation.

5. Circuit intégré logique selon l'une des revendications 1 à 4, caractérisé par le fait que certains conducteurs de ligne sont isolés de la surface d'un substrat essentiellement par un isolant épais sauf au-dessus de régions constituant des canaux entre source et drain de transistors MOS de disposition normale (fig. 8), l'isolant étant mince à ces endroits, et sauf au-dessus de régions de drain (72) de transistors MOS de disposition inversée (fig. 9), le conducteur de ligne venant en contact direct avec la région de drain à ces endroits.

6. Circuit intégré logique selon l'une quelconque des revendications 1 à 5, caractérisé par le fait que certains conducteurs de colonnes sont, dans la zone d'implantation du réseau, isolés des conducteurs de ligne et du substrat par un isolant épais sauf dans des régions (88) de court-circuit entre ligne et colonne (fig. 10) et sauf dans des régions (68) de drain de transistors de disposition normale (fig. 8) où le conducteur de colonne vient en contact avec le drain du transistor.

7. Circuit intégré logique selon l'une quelconque des revendications 1 à 6, caractérisé par le fait que les conducteurs de ligne sont constitués par des bandes (60) d'une couche conductrice, et que cette couche conductrice comprend par ailleurs des portions isolées individuelles (74) disposées chacune à une région de croisement comprenant un transistor de disposition inversée (fig. 9), ces portions venant en contact avec le conducteur de colonne (76) correspondant à ce croisement mais étant isolées du conducteur de ligne (60), et ces portions constituant les grilles des transistors de disposition inversée isolées du substrat par une couche isolante mince au-dessus de la région de canal entre source (66) et drain (72) de ces transistors.

8. Circuit intégré logique selon l'une quelconque des revendications 1 à 7, caractérisé par le fait qu'une ligne fortement dopée (64) parallèle à un conducteur de ligne est prévue pour relier à la masse des électrodes de source de transistors, et que dans des régions de croisement correspondant à un transistor de disposition inversée (fig. 9) la région de drain (72) de ce transistor est située entre la ligne fortement dopée (64) et le conducteur de ligne (60).

9. Circuit intégré logique selon la revendication 8, caractérisé par le fait que la région de drain (72) est située latéralement par rapport au conducteur de colonne (76, fig. 9).

10. Circuit intégré logique selon l'une quelconque des revendications 1 à 9, caractérisé par le fait que les conducteurs de ligne sont en silicium polycristallin et les conducteurs de colonne en aluminium.

**Claims**

1. Integrated logic circuit comprising a pattern of line conductors and a pattern of column conductors crossing each other in a zone of implantation of logic gates, certain regions of crossing between a line conductor and a column conductor comprising an insulation between these two conductors and other regions comprising a transistor in a so-called « normal » arrangement (X) having a main electrode (68) connected to a column conductor (62) and a control electrode (69) connected to a line conductor (60), characterized by the fact that other regions of crossings between a line conductor and a column conductor, both of which are further connected to normal arrangement transistors at the crossing regions of the same implantation zone, comprise a transistor in a so-called « inverted » arrangement (0) having a main electrode (72) connected to the line conductor (60) and a control electrode (74) connected to the column conductor (76).

2. Integrated logic circuit according to claim 1, characterized by the fact that the implantation zone simultaneously comprises crossing regions with a short circuit between the line conductor and the column conductor and others with a transistor of inverted arrangement.

3. Integrated logic circuit according to any of claims 1 and 2, characterized by the fact that another main electrode (66) of the inverted arrangement transistors and of the normal arrangement transistors is connected to a ground line (64) common to a plurality of transistors of the implantation zone.

4. Integrated logic circuit according to any of claims 1 to 3, characterized by the fact that certain columns (A, B, F, G ; Figure 7) are connected through individual loads to a supply potential source and that certain lines (C, D, E, H ; Figure 7) are likewise connected through individual loads to a supply potential source.

5. Integrated logic circuit according to any of claims 1 to 4, characterized by the fact that certain line conductors are insulated from the surface of a substrate essentially by a thick insulation except above regions forming channels between source and drain of the MOS transistors in normal arrangement (Figure 8), the insulation being thin at these locations, and except above drain regions (72) of MOS transistors of inverted arrangement (Figure 9), the line conductor directly contacting the drain region at these locations.

6. Integrated logic circuit according to any of claims 1 to 5, characterized by the fact that certain column conductors are insulated from the line conductors and from the substrate in the implantation zone of the pattern by a thick insulation except in regions (88) of a short circuit between line and column (Figure 10) and except in drain regions (68) of normal arrangement transistors (Figure 8) where the column conductor contacts the drain of the transistor.

7. Integrated logic circuit according to any of claims 1 to 6, characterized by the fact that the line conductors are formed of strips (60) of a conductive layer and that this conductive layer further comprises individual insulated portions (74) each located at a crossing region comprising an inverted arrangement transistor (Figure 9), these portions contacting the column conductor (76) corresponding to this crossing but being insulated from the line conductor (60), and these portions forming the gates of the inverted arrangement transistors insulated from the substrate by a thin insulating layer above the channel region between the source (66) and drain (72) of these transistors.

8. Integrated logic circuit according to any of claims 1 to 7, characterized by the fact that a highly doped line (64) is provided in parallel to a line conductor for connecting to ground the source electrodes of transistors, and in that in the crossing regions corresponding to an inverted arrangement transistor (Figure 9) the drain region (72) of this transistor is located between the highly doped line (64) and the line conductor (60).

9. Integrated logic circuit according to claim 8, characterized by the fact that the drain region (72) is located laterally with respect to the column conductor (76, Figure 9).

10. Integrated logic circuit according to any of claims 1 to 9, characterized by the fact that the line conductors are of polycrystalline silicon and the column conductors of aluminium.


**Patentansprüche**

1. Integrierte Logikschaltung mit einem Netzwerk aus Zeilenleitern und einem Netzwerk aus Spaltenleitern, die sich in einer Zone der Implantation von Logikgattern kreuzen, wobei bestimmte Kreuzungsgebiete zwischen einem Zeilenleiter und einem Spaltenleiter eine Isolierung zwischen diesen zwei Leitern und andere Bereiche einen Transistor in sogenannter Normalanordnung (X) enthalten, der eine mit einem Spaltenleiter (62) verbundene Hauptelektrode (68) und eine mit einem Zeilenleiter (60) verbundene Steuerelektrode (69) aufweist, dadurch gekennzeichnet, daß andere Kreuzungsgebiete zwischen einem Zeilenleiter und einem Spaltenleiter, die im übrigen beide an den Kreuzungsgebieten derselben Implantationszone mit Transistor in Normalanordnung verbunden sind, einen Transistor in sogenannter « inverser » Anordnung (0) umfassen, der eine mit dem Zeilenleiter (60) verbundene Hauptelektrode (72) und eine mit dem Spaltenleiter (76) verbundene Steuerelektrode (74) aufweist.

2. Integrierte Logikschaltung nach Anspruch 1, dadurch gekennzeichnet, daß die Implantationszone gleichzeitig Kreuzungsgebiete mit Kurzschluß zwischen dem Zeilenleiter und dem Spaltenleiter und weitere mit einem Transistor in inverser Anordnung enthält.

3. Integrierte Logikschaltung nach einem der Ansprüche 1 und 2, dadurch gekennzeichnet, daß eine weitere Hauptelektrode (66) der Transistoren mit inverser Anordnung und der Transistoren in Normalanordnung mit einer Masseleitung (64) verbunden ist, die mehreren Transistoren der Implantationszone gemeinsam ist.

4. Integrierte Logikschaltung nach einem der Ansprüche 1 bis 3, dadurch gekennzeichnet, daß bestimmte Spalten (A, B, F, G ; Figur 7) über individuelle Lasten mit einer Versorgungspotentialquelle verbunden sind und bestimmte Zeilen (C, D, E, H ; Figur 7) ebenfalls über individuelle Lasten mit einer Versorgungspotentialquelle verbunden sind.

5. Integrierte Logikschaltung nach einem der Ansprüche 1 bis 4, dadurch gekennzeichnet, daß bestimmte Zeilenleiter gegen die Oberfläche eines Substrates im wesentlichen durch ein dickes Isoliermittel isoliert sind, außer über Gebieten, welche Kanäle zwischen Source-Elektrode und Drain-Elektrode von MOS-Transistoren in Normalanordnung bilden (Figur 8), wobei das Isoliermittel an diesen Stellen dünn ist, und außer über Drain-Gebieten (72) von MOS-Transistoren in inverser Anordnung (Figur 9), wobei der Zeilenleiter an diesen Stellen in direkte Berührung mit dem Drain-Gebiet gelangt.

6. Integrierte Logikschaltung nach einem der Ansprüche 1 bis 5, dadurch gekennzeichnet, daß bestimmte Spaltenleiter in der Implantationszone des Netzwerks von den Zeilenleitern und vom Substrat durch ein dickes Isoliermittel isoliert sind, außer in Kurzschlußgebieten (88) zwischen Zeile und Spalte (Figur 10) und außer in Drain-Gebieten (68) von Transistoren in Normalanordnung (Figur 8), wo der Spaltenleiter in Berührung mit dem Drain des Transistors gelangt.

7. Integrierte Logikschaltung nach einem der Ansprüche 1 bis 6, dadurch gekennzeichnet, daß die Zeilenleiter durch Streifen (60) einer leitfähigen Schicht gebildet sind und daß diese leitfähige Schicht im übrigen individuelle isolierte Teile (74) umfaßt, die jeweils in einem Kreuzungsgebiet angeordnet sind, welches einen Transistor in inverser Anordnung (Fig. 9) enthält, wobei diese Teile mit den Spaltenleitern (76) in Berührung kommen, welche dieser Kreuzung entsprechen, von dem Zeilenleiter (60) jedoch isoliert sind, und wobei diese Teile die Gates der Transistoren in inverser Anordnung bilden, welche von dem Substrat durch eine dünne Isolierschicht über dem Kanalbereich zwischen Source (66) und Drain (73) dieser Transistoren isoliert sind.

8. Integrierte Logikschaltung nach einem der Ansprüche 1 bis 7, dadurch gekennzeichnet, daß eine hochdotierte Zeile (64) parallel zu einem Zeilenleiter vorgesehen ist, um die Source-Elektroden von Transistoren mit Masse zu verbinden, und daß in den Kreuzungsgebieten, welche einem Transistor in inverser Anordnung (Figur 9) entsprechen, das Drain-Gebiet (72) dieses Transistors zwischen der hochdotierten Zeile (64) und dem Zeilenleiter (60) angeordnet ist.

9. Integrierte Logikschaltung nach Anspruch 8, dadurch gekennzeichnet, daß das Drain-Gebiet (72) seitlich in Bezug auf den Spaltenleiter (76, Figur 9) liegt.

10. Integrierte Logikschaltung nach einem der Ansprüche 1 bis 9, dadurch gekennzeichnet, daß die Zeilenleiter aus polykristallinem Silizium und die Spaltenleiter aus Aluminium sind.

Fig.1

$$S1 = a_1 a_n + a_1 a_2 + a_3 a_{n-1}$$

$$S2 = a_1 a_2$$

$$Sp = a_1 a_2 + a_3 a_{n-1}$$

Fig.2

Fig.3

Fig.4

Fig.5

Fig.6

Fig.7

Fig.8

Fig.9

Fig.10

4